# EUROPÄISCHE PATENTANMELDUNG

(11) **EP 2 434 587 A1**
(43) Veröffentlichungstag der Anmeldung: **28.03.2012**
(21) Anmeldenummer: 10179229.9
(22) Anmeldetag: 24.09.2010
(51) Int. Cl.: H01R 13/627

(54) **Verbindungsvorrichtung für elektrische Leitungen**

(71) Anmelder: Lapp Engineering & Co., 6330 Cham (CH)
(72) Erfinder: Krech, Jahann, 72160, Horb am Neckar (DE)
(74) Vertreter: Rutz & Partner

(57) **Zusammenfassung**

Die insbesondere für Fotovoltaik-Geräte vorgesehene Verbindungsvorrichtung (10), umfasst ein der Verbindung mit mindestens einer ersten Leitung (20) dienendes erstes Vorrichtungsteil (12), welches ein erstes Gehäuse (16) und wenigstens einen darin vorgesehenen ersten Anschlusskontakt (24) aufweist, und ein zweites Vorrichtungsteil (14), welches der Verbindung mit mindestens einer zweiten Leitung (22) dient und ein zweites Gehäuse (18) und wenigstens einen darin vorgesehenen zweiten Anschlusskontakt (26) aufweist. Die Verbindungsvorrichtung (10) weist weiter eine Verriegelungsvorrichtung mit wenigstens einem am ersten Gehäuse (16) vorgesehenen ersten und wenigstens einem am zweiten Gehäuse (18) vorgesehenen zweiten Verriegelungselement (30, 32) auf, die beim Verbinden der Vorrichtungsteile (12, 14) miteinander koppelbar sind. Erfindungsgemäss weisen die beiden Verriegelungselemente (30, 32) wenigstens teilweise zueinander komplementäre Formen auf, die nach dem Verbinden der beiden Vorrichtungsteile (12, 14) zumindest teilweise formschlüssig aneinander liegen, wobei wenigstens eines der beiden Verriegelungselemente (30, 32) elastisch ausgestaltet ist und unter Einwirkung einer definierten Zugkraft (50) derart deformiert wird, dass die Verbindung selbsttätig und zerstörungsfrei gelöst wird.

## Beschreibung

Die vorliegende Erfindung betrifft eine mit einer Verriegelungsvorrichtung versehene Verbindungsvorrichtung für elektrische Leitungen nach dem Oberbegriff des Patentanspruchs 1.

Zum Verbinden elektrischer Geräte, die der Erzeugung, Weiterleitung oder der Verarbeitung elektrischer Energie, insbesondere auch elektrischer Signale dienen, werden elektrische Leitungen und entsprechende Verbindungsvorrichtungen, wie Kabelverbinder oder Steckverbinder verwendet. Durch diese Verbindungsvorrichtungen können z.B. zwei elektrische Kabel oder Leitungen, wie eine mit einem Versorgungsnetz verbundene Versorgungsleitung und eine mit einem elektrischen Verbraucher verbundene Anschlussleitung miteinander verbunden werden. Eine Verbindungsvorrichtung erlaubt es ferner, eine Anschlussleitung bzw. ein Anschlusskabel mit elektrischen Leitungen eines Gerätes zu verbinden, die zu peripheren Anschlusskontakten des Gerätes geführt sind. Beispielsweise werden Starkstromkabel oder Signalkabel z.B. der Telekommunikation zu entsprechenden Anschlussvorrichtungen des Gerätes geführt, an die externe Leitungen, einschliesslich Kabel, angeschlossen werden. Oft werden in diesen Geräten auch Leiterplatten verwendet, auf denen die elektrischen Leitungen aufgedruckt sind. Die verwendeten Verbindungsvorrichtungen erlauben es dabei, miteinander verbundene elektrische Leitungen oder an Geräte angeschlossene elektrische Leitungen wahlweise wieder voneinander zu lösen.

Eine Verbindungsvorrichtung dieser Art, die für den Einsatz im Fotovoltaikbereich vorgesehen ist, nämlich ein Steckverbinder, ist aus der Gebrauchsmusterschrift DE 20 2007 017 521 U1 bekannt. Der Steckverbinder mit einem Stecker weist einen Griffkörper auf, welcher in Einsteckrichtung orientiert wenigstens ein Rastmittel und einen Kontaktträger umfasst. Ein Griffkörper einer Buchse des Steckverbinders bildet eine Kontaktträgeraufnahme und ein mit dem Rastmittel korrespondierendes Gegenrastmittel aus. Das Rastmittel und das Gegenrastmittel sichern im gesteckten Zustand den Stecker und die Buchse. Dabei bilden der Kontaktträger und die Kontaktträgeraufnahme miteinander korrespondierende Positionierungsmittel, die ein Einstecken des Steckers in die Buchse nur bei den Gegenrastmitteln zugewandten Rastmitteln ermöglichen.

Fotovoltaikanlagen umfassen gewöhnlich eine Vielzahl von Solarpanels, mittels derer elektrische Energie erzeugt wird. Diese Solarpanels weisen abgehende Kabelsätze auf, welche die erzeugte elektrische Energie über verschiedene technische Einrichtungen schliesslich zu einem Netzübergabepunkt führen. Aus Gründen der Montagefreundlichkeit ist es mittlerweile üblich, die Solarpanels, sowie die zugehörigen Leitungen, welche die elektrische Energie abführen, mit einer Verbindungsvorrichtung bzw. mit einer streckbaren Kabelkupplung auszurüsten.

Aus Gründen der Betriebssicherheit werden an die Zuverlässigkeit gattungsgemässer Verbindungsvorrichtungen hohe Ansprüche gestellt. So muss beispielsweise gewährleistet sein, dass sich derartige Verbindungsvorrichtung nicht selbsttätig trennen. Die Verbindungsvorrichtung muss einer gewissen Zugkraft, die auf das Kabel einwirkt, standhalten, damit die Verbindungsvorrichtung nicht selbsttätig oder durch Fremdeinwirkung getrennt wird.

Beim Verbinden oder Trennen der Verbindungsvorrichtung sollen dabei jeweils definierte Zustände erreicht werden, bei denen Anschlusskontakte entweder zuverlässig miteinander verbunden oder zuverlässig voneinander getrennt sind. Sofern die Verbindungsvorrichtung hingegen nur unvollständig gelöst wird, kann unter Umständen weiter elektrische Energie über die Verbindungsvorrichtung übertragen werden. Typischerweise erhöht sich dabei der Wert des Übergangswiderstandes zwischen den elektrischen Kontaktflächen der Verbindungsvorrichtung. Die Erhöhung des Übergangswiderstandes führt zu einer erhöhten Leistungsaufnahme, die zu einer Erwärmung der Verbindungsvorrichtung führt. Bei der Übertragung hoher elektrischer Leistungen kann auch ein Plasmalichtbogen entstehen. Als Folge dieser Zustände ist mit einer Zerstörung der Verbindungsvorrichtung zu rechnen. Ferner können im Einzelfall Brände oder weitere Schäden, insbesondere auch Betriebsausfälle verursacht werden.

Eine weitere Gefahr besteht darin, dass bei einer axial auf ein Kabel wirkenden Zugkraft der Leiter aus dem Verbindungsvorrichtung ausgerissen wird. Um ein Ausreissen zu verhindern, wird das Kabel daher zumeist fest mit dem Stecker verbunden. Häufig wird eine spezielle Zugentlastung vorgesehen, mittels der das Kabel mit der Verbindungsvorrichtung gekoppelt wird. Installierte Verbindungsvorrichtungen, insbesondere für Fotovoltaikanlagen, sind deshalb oft sowohl mit einer Verriegelungsvorrichtung, welche das selbständige Trennen oder das ungenügende Verbinden verhindern, als auch mit einer Zugentlastung ausgerüstet.

Bei den beschriebenen Verbindungsvorrichtungen, die eine stabile Verbindung zwischen elektrischen Leitungen gewährleisten, können jedoch Probleme auftreten, wenn auf eine der Leitungen eine hohe Zugkraft ausgeübt wird, die gegebenenfalls über die Zugentlastung auf ein elektrisches Gerät oder die zweite Leitung übertragen wird. Dies kann beispielsweise der Fall sein, wenn eine Person über ein Kabel stolpert oder ein elektrisches Gerät herunter fällt. In diesen Fällen wird die Verbindungsvorrichtung unter Umständen zerstört oder beschädigt. Gegebenenfalls werden elektrische Leiter aus der Verbindungsvorrichtung und der Isolation gelöst und freigelegt, so dass Kurzschlüsse auftreten oder Personen durch Stromschlag gefährdet werden können. Weiterhin ist es möglich, dass nicht fest montierte Geräte aus ihrer Position gerissen und beschädigt werden.

Der vorliegenden Erfindung liegt daher die Aufgabe zugrunde, eine verbesserte mit einer Verriegelungsvorrichtung versehene Verbindungsvorrichtung für elektrische Leitungen zu schaffen.

Die Verbindungsvorrichtung soll es erlauben, ein- oder mehradrige Leitungen miteinander zu verbinden und wahlweise wieder voneinander zu lösen.

Insbesondere ist eine leicht handhabbare Verbindungsvorrichtung zu schaffen, bei der die oben beschriebenen Nachteile beim Auftreten hoher Zugkräfte vermieden werden. Insbesondere sollen in diesen Fällen die Zerstörung der Verbindungsvorrichtung, eine Gefährdung von Personen sowie Beschädigungen elektrischer Geräte vermieden werden.

Diese Aufgabe wird mit einer Verbindungsvorrichtung gelöst, welche die in Anspruch 1 angegebenen Merkmale aufweist. Vorteilhafte Ausgestaltungen der Erfindung sind in weiteren Ansprüchen angegeben.

Die Vorrichtung dient der Verbindung von ein- oder mehradrigen elektrischen Leitungen, insbesondere von Leitungen für Fotovoltaik-Geräte. Die Verbindungsvorrichtung umfasst ein der Verbindung mit mindestens einer ersten Leitung dienendes erstes Vorrichtungsteil, welches ein erstes Gehäuse und wenigstens einen darin vorgesehenen ersten Anschlusskontakt aufweist. Weiter ist ein der Verbindung mit mindestens einer zweiten Leitung dienendes zweites Vorrichtungsteil vorgesehen, welches ein zweites Gehäuse und wenigstens einen darin vorgesehenen zweiten Anschlusskontakt aufweist. Die Verbindungsvorrichtung weist weiter eine Verriegelungsvorrichtung mit wenigstens einem am ersten Gehäuse vorgesehenen ersten und wenigstens einem am zweiten Gehäuse vorgesehenen zweiten Verriegelungselement auf. Die Verriegelungselemente sind beim Verbinden der beiden Vorrichtungsteile miteinander koppelbar, so dass ein selbsttätiges Lösen der Vorrichtungsteile verhindert wird.

Erfindungsgemäss weisen die beiden Verriegelungselemente wenigstens teilweise zueinander komplementäre Formen auf, die nach dem Verbinden der beiden Vorrichtungsteile zumindest teilweise formschlüssig aneinander liegen, wobei wenigstens eines der beiden Verriegelungselemente elastisch ausgestaltet ist. Unter Einwirkung einer definierten Zugkraft, welche auf einer der Leitungen zumindest annähernd parallel zu einer Verbindungsachse auf die Verbindungsvorrichtung einwirkt, wird eines der beiden Verriegelungselemente derart deformiert, dass die formschlüssige Verbindung selbsttätig und zerstörungsfrei lösbar ist.

Durch das selbsttätige Lösen der Verriegelungselemente beim Überschreiten der definierten Zugkraft, wird eine schnelle und vollständige Trennung der Verbindungsvorrichtung gewährleistet, wodurch Probleme, die bei höheren Zugkräften auftreten könnten, vermieden werden. Unterhalb der definierten Zugkraft bzw. im Bereich zulässiger Zugkräfte wird ein selbsttätiges Lösen der Vorrichtungsteile zuverlässig vermieden. Erst oberhalb der definierten Zugkraft bzw. im Bereich gefährlicher Zugkräfte erfolgt ein selbsttätiges Lösen der Vorrichtungsteile.

Dadurch werden verschiedene Probleme vermieden, die zu erheblichen Sachschäden und Personenschäden führen könnten.

Beim Überschreiten der definierten Zugkraft erfolgt eine vollständige Trennung der beiden Vorrichtungsteile. Dadurch wird eine unvollständige Trennung vermieden, bei welcher die Anschlusskontakte über einen erhöhten Übergangswiderstand miteinander in Verbindung bleiben, an dem elektrische Energie in Wärme umgesetzt wird, die zu einer Zerstörung der Verbindungsvorrichtung führen kann.

Durch das Lösen der Verriegelungselemente bzw. der Vorrichtungsteile bei einer definierten Zugkraft wird zudem vermieden, dass die Verbindungsvorrichtung aufgrund der einwirkenden Kräfte zerstört wird oder eine der Leitungen oder einzelne Adern ausgerissen und freigelegt werden. Eine mögliche Gefährdung von Personen sowie das Auftreten von Kurzschlüssen werden daher vermieden. Insbesondere bei Geräten und Installationen aus dem Bereich der Fotovoltaik, die der Erzeugung von Strom dienen, werden dabei nicht zu unterschätzende Gefahrenpotenziale beseitigt.

Besonders wichtig ist ferner, dass beim erfindungsgemässen Vorgang der Trennung der Vorrichtungsteile die Verriegelungselemente nicht zerstört werden. Nach dem Auftreten einer Zugkraft oberhalb des definierten Grenzwerts und der Trennung der Vorrichtungsteile, können diese nach der Beseitigung der Ursache der Krafteinwirkung wieder zusammengesetzt werden.

In einer bevorzugten Ausgestaltung ist das erste Verriegelungselement zungenförmig ausgestaltete und weist wenigstens einen Hebel auf, in dessen Endbereich wenigstens ein vorzugsweise keilförmig ausgestalteter Rastkörper angeordnet ist. Das zweite Verriegelungselement weist einen der Aufnahme des Hebels dienenden Tunnel sowie eine der Aufnahme des Rastkörpers dienende Rastsenke auf. Der Hebel und der Tunnel sind dabei annähernd parallel zu der Verbindungsachse ausgerichtet und entlang der beiden Vorrichtungsteile ineinander verschiebbar. Durch die zungenförmige Ausgestaltung des ersten Verriegelungselements kann der am Hebel vorgesehene Rastkörper vollständig durch den Tunnel hindurch geführt werden und ausgangsseitig an diesem anliegen. Dies führt zu einem leichtgängigen Zusammenführen sowie einer festen mechanischen Verbindung der beiden Verriegelungselemente.

Vorzugsweise ist der Rastkörper am Ende des Hebels in dessen Mitte angeordnet. Durch die mittige Anordnung des Rastkörpers kann die Verbindungsvorrichtung ohne ein Werkzeug, beispielsweise mit zwei Fingern getrennt werden.

Alternativ werden zwei voneinander beabstandete Rastkörper am Ende des Hebels seitlich angeordnet. In diesem Fall ist zum Lösen der Verbindungsvorrichtung ein Werkzeug notwendig. Dritte, die kein entsprechendes Werkzeug besitzen, können die Verbindung unbefugterweise daher nicht lösen. Insbesondere wird diese Lösung auch als Kindersicherung verwendet, welche eine Gefährdung von Kindern beseitigt.

In einer vorzugsweisen Ausgestaltung weist der Rastkörper eine rückseitige Keilfläche auf, die gegenüber der Verbindungsachse geneigt ist und die im verriegelten Zustand wenigstens teilweise an einer Auflagefläche der zugehörigen Rastsenke anliegt. Somit werden ein Einrasten und eine Verriegelung der Verbindungsvorrichtung erreicht, nachdem die Vorrichtungsteile ineinander verschoben wurden und der Rastkörper den Tunnel vorzugsweise vollständig durchlaufen hat. Durch das Einrasten und das damit verbundenen Klicken wird der Person, welche die beiden Vorrichtungsteile zusammenführt, angezeigt, dass die Endposition erreicht wurde und die Anschlusskontakte aneinander liegen. Ein selbsttätiges Auftrennen der Verbindungsvorrichtung bei kleineren Zugkräften wird daher vermieden. Bei einer unbeabsichtigten Manipulation der Verbindungsvorrichtung bleibt die Verbindung erhalten.

Die rückseitige Keilfläche des Rastkörpers schliesst mit der Verbindungsachse bzw. dem Hebel vorzugsweise einen Winkel im Bereich 85° - 89.5°, besonders bevorzugt im Bereich 88.5° - 89.5°, ein.

Vorzugsweise liegt die Keilfläche nicht flach auf der Auflagefläche der zugehörigen Rastsenke auf. Bei der Ausübung einer axialen Zugkraft auf eines der beiden Vorrichtungsteile bzw. auf eine der damit verbundenen Leitungen, werden die beiden Flächen gegeneinander gedrückt, wodurch ein Drehmoment resultiert, welches ein Ende des Hebels aus seiner Ruheposition im verriegelten Zustand gegen die Mittelachse der Verbindungsvorrichtung wegdrückt. Bei genügend hoher Zugkraft gleitet der Rastkörper entlang der gesamten Auflagefläche geführt, bis er frei im Tunnel verschoben werden kann und die Verbindungsvorrichtungen dadurch entriegelt sind.

Die Höhe der Keilfläche liegt vorzugsweise im Bereich von 0,3mm - 1,5mm und die Gesamtbreite der Keilfläche des wenigstens einen Rastkörpers liegt vorzugsweise im Bereich von 2mm - 6mm. In vorzugsweisen Ausgestaltungen weist die Keilfläche eine geringere Breite auf, als die Vorderkante des Hebels. Der Rastkörper wird vorzugsweise auf jeder Seite der Keilfläche mit einer Seitenfläche versehen, die gegenüber der Keilfläche geneigt ist. Dadurch lassen sich die beiden Vorrichtungsteile leichtgängig zusammenführen und verriegeln. Bei zu geringer Breite oder zu grosser Höhe der Keilfläche besteht die Gefahr, dass der Rastkörper bei einer erhöhten Krafteinwirkung oder bei mehrmaliger Betätigung der Verbindungsvorrichtung beschädigt wird. Die Ausgestaltung des Rastkörpers erlaubt daher eine vorteilhafte und schonende Bedienung der Verbindungsvorrichtung, wobei gleichzeitig die Funktion der automatischen Entriegelung bei Erreichen der definierten Zugkraft realisiert wird.

Die Auflagefläche liegt vorzugsweise am Ende des Tunnels, vorzugsweise auf der der Verbindungsachse abgewandten Seite des Tunnels und ist zumindest annähernd senkrecht zur Verbindungsachse ausgerichtet. Durch die Position der Auflagefläche am Ende des Tunnels kann der Rastkörper automatisch in die Rastsenke eindringen bzw. entlang der Auflagefläche gleiten, wonach eine feste Verriegelung der Verbindungsvorrichtung resultiert.

Die Höhe der Auflagefläche liegt vorzugsweise im Bereich von 0,2mm - 0,6mm. Die Auflagefläche ist kleiner als die Keilfläche. Dadurch wird die Auflagefläche von der Keilfläche hintergriffen. Dies verbessert die Verriegelung. Zusätzlich wird eine höhere Zugkraft definiert, die zur Entriegelung der Verbindungsvorrichtung erforderlich ist.

Der Hebel weist vorzugsweise eine Länge im Bereich von 7mm - 15mm auf und eine radial zur Verbindungsachse verlaufende Dicke im Bereich von 0, 5mm - 2mm und eine senkrecht zur Länge und Dicke verlaufende Breite im Bereich von 4mm - 9mm. Die Geometrie des Hebels sowie dessen Materialbeschaffenheit bestimmen dessen Elastizität.

Mit den angegebenen Spezifikationen des Hebels vermögen die Verriegelungselemente eine zumindest annähernd axial zur Verbindungsachse verlaufende Zugkraft im Bereich von 50N - 300N, vorzugsweise 80N - 150N, aufzunehmen. Dadurch wird gewährleistet, dass sich die Verbindungsvorrichtung nicht bereits bei üblicherweise auftretenden Zugkräften lösen kann. Ferner wird dadurch eine Entriegelung bei einer entsprechend definierten Zugkraft erreicht.

In vorzugsweisen Ausgestaltungen wird eine mechanische Verbindung zwischen der Leitung und dem zugehörigen Vorrichtungsteil vorgesehen, welche eine zumindest annähernd axial zur Verbindungsachse verlaufende Zugkraft im Bereich von 300N - 500N aufzunehmen vermag. Entsprechende Zugkräfte wirken daher nicht auf die Anschlusskontakte, sondern direkt auf das Vorrichtungsteil ein. Das Lösen der Leitungsadern von den Anschlusskontakten und dadurch resultierende Wackelkontakte werden vermieden.

Die Vorrichtungsteile sind vorzugsweise derart ausgestaltet, dass nach deren Trennung, die Anschlusskontakte durch eine Isolation gegen Berührung geschützt sind. Dadurch wird das Risiko gegen elektrischen Schlag oder von Kurzschlüssen reduziert. Bei einer Auftrennung der Verbindungsvorrichtung verursacht durch das Überschreiten der definierten Zugkraft entsteht daher keine Gefährdung von Personen oder installierten Geräten.

Durch die Fertigung der Vorrichtungsteile aus einem entsprechenden Kunststoff, vorzugsweise modifiziertem Polyphenylenether (PPE), kann sowohl eine gute Isolation der Verbindungsvorrichtung, als auch eine genügende Elastizität der Verriegelungselemente erreicht werden. Polyphenylenether ist ein hochtemperaturbeständiger, thermoplastischer Kunststoff. Vorzugsweise wird ein Kunststoff verwendet, der auch beim Einsatz im Freien, UV-beständig ist.

Nachfolgend wird die Erfindung anhand von Zeichnungen näher erläutert. Dabei zeigt:
- Fig. 1: eine erfindungsgemässe Verbindungsvorrichtung 10 für elektrische Leitungen 20, 22 mit zwei Vorrichtungsteilen 12, 14 mit je einem Gehäuse 16, 18 und einem darin vorgesehenen Anschlusskontakt 24, 26 sowie je zwei Verriegelungselementen 30, 32;
- Fig. 2: das erste Vorrichtungsteil 12 von Figur 1 in einer Detailansicht mit einem Hebel 34 und einem Rastkörper 36;
- Fig. 3: das erste Vorrichtungsteil 12 von Figur 1 mit einer Detailansicht eines ersten Verriegelungselements 30, welches einen Hebel 34 und einen keilförmigen Rastkörper 36 aufweist, der eine gegenüber dem Hebel 34 um einen Winkel von 88,5° bis 89,5° geneigte Keilfläche 38 aufweist;
- Fig. 4: das zweite Vorrichtungsteil 14 von Figur 1 mit einer Detailansicht eines zweiten Verriegelungselements 32, welches einen Tunnel 40 und eine Rastsenke 42 mit einer Auflagefläche 44 aufweist;
- Fig. 5: den Ablauf der Entriegelung der Verriegelungselemente 30, 32, die erfolgt wenn eine definierte axiale Zugkraft auf einer Leitung 20, 22 überschritten wird;
- Fig. 6: eine weitere erfindungsgemässe Verbindungsvorrichtung 10 mit zwei weiteren Verriegelungselementen 30, 32 welche nur mit einem Werkzeug voneinander gelöst werden können;
- Fig. 7: das erste Vorrichtungsteil 12 von Figur 6 in räumlicher Darstellung, mit ersten Verriegelungselementen 30, die je einen Hebel 34 mit zwei Rastkörpern 36 aufweisen; und
- Fig. 8: das zweite Vorrichtungsteil 14 von Figur 6 in einer Schnittansicht mit einem Tunnel 40, einer Rastsenke 42, sowie einer Zugentlastung 54.

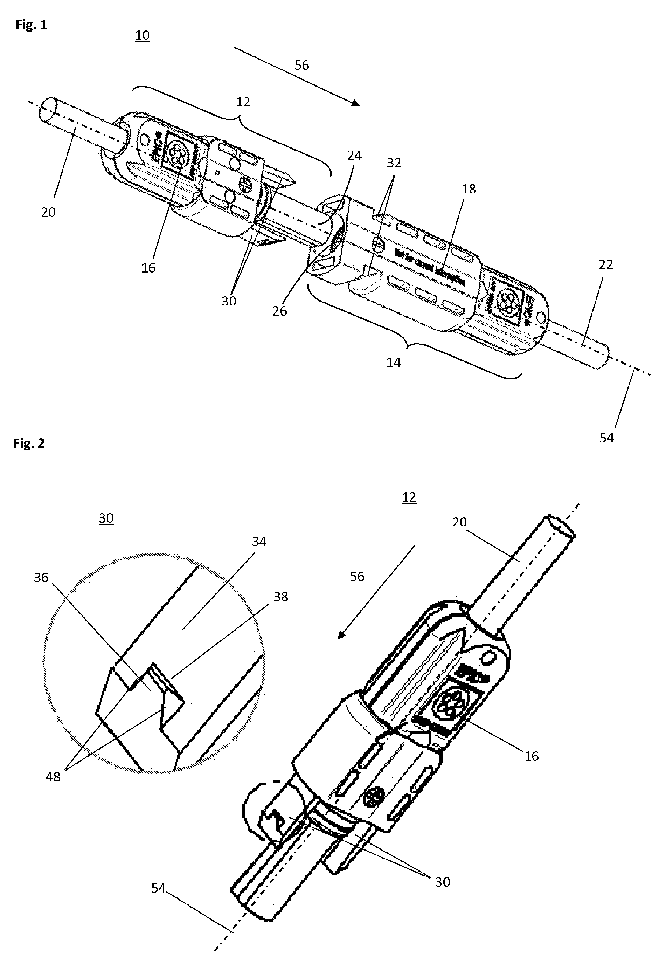

Figur 1 zeigt eine erfindungsgemässe Verbindungsvorrichtung 10, mittels der zwei elektrische Leitungen 20, 22 miteinander verbindbar sind. Die entsprechende Verbindungsvorrichtungen 10 können z.B. vorteilhaft bei Fotovoltaik-Anlagen eingesetzt werden. Durch die Verbindungsvorrichtungen 10 können einzelne Teile elektrischer Anlagen, wie Fotovoltaikanlage, beispielsweise zu Wartungszwecken oder im Fall, dass die Anlage erweitert werden soll mühelos getrennt und später wieder mit dem entsprechenden Gegenstück verbunden werden.

Die Verbindungsvorrichtung 10 besteht aus einem ersten Vorrichtungsteil 12 und einem zweiten Vorrichtungsteil 14, die je mit einer Leitung 20, 22, beispielsweise einem Stromversorgungskabel, einem Datenkabel der Telekommunikation oder der Computertechnik, oder Leitungen verbunden sind, welche auf einer Leiterplatte aufgedruckt sind. Die Leitungen der in einem Gerät angeordneten Leiterplatte werden üblicherweise direkt oder über ein Zwischenkabel zum zugehörigen Vorrichtungsteil 14, 16 geführt, welches an einer passenden Stelle des Gehäuses des Geräts angeordnet ist.

Die beiden Vorrichtungsteile 12, 14 umfassen je ein Gehäuse 16, 18 in welchem wenigstens ein Anschlusskontakt 24, 26 untergebracht ist, der mit einer Ader der zugehörigen Leitung 20, 22 verbunden ist. Typischerweise sind mehrere gegeneinander isolierte Anschlusskontakte 24, 26 vorgesehen.

Das in Figur 1 gezeigte erste Vorrichtungsteil 12 umfasst als Anschlusskontakt 24 eine Buchse welche in einem hohlzylindrischen Isolationskörper angeordnet ist. Durch den Isolationskörper wird verhindert, dass Personen in Kontakt mit dem Anschlusskontakt 24 gelangen können, an dem auch dann eine hohe Spannung anliegen kann, wenn die Vorrichtungsteile 12, 14 voneinander getrennt sind. Gleichzeitig wird verhindert, dass der Anschlusskontakt 24 in einen unerwünschten Kontakt mit weiteren Kontakten gelangen und einen Kurzschluss verursachen kann. Ein als Steckkontakt ausgebildeter zweiter Anschlusskontakt 26 ist im zweiten Vorrichtungsteil 14 untergebracht und derart im Gehäuse 18 eingebettet, dass unerwünschte Berührungen mit Personen oder weiteren Kontakten vermieden werden.

An der Frontseite des Gehäuses 16 bzw. 18 der beiden Vorrichtungsteile 12, 14 sind beidseits der Verbindungsachse 54 je zwei Verriegelungselemente 30, 32 angeordnet. Diese greifen beim Verbinden der beiden Vorrichtungsteile 12, 14 ineinander und verriegeln die Vorrichtungsteile 12, 14 in einer definierten Position. Durch diese Verriegelung wird sichergestellt, dass die aneinander anliegenden Anschlusskontakte 24, 26 in Position gehalten bleiben und stets eine optimale Verbindung zwischen den Anschlusskontakten 24, 26 vorliegt.

Die Verriegelungselemente 30, 32 weisen zueinander komplementäre Formen auf, so dass sie nach dem Verbinden der beiden Vorrichtungsteile 12, 14 möglichst formschlüssig ineinander greifen. Mindestens eines der beiden Verriegelungselemente 30, 32 ist dabei elastisch. Durch die Elastizität, sowie die Form der Verriegelungselemente 30, 32 wird erfindungsgemäss erreicht, dass sich die beiden Vorrichtungsteile 12, 14 beim Auftreten einer Zugkraft, die über einem definierten Wert liegt, selbsttätig löst. Unterhalb dieses Werts wird durch die Verriegelung ein selbsttätiges Öffnen der Verbindungsvorrichtung verhindert. Sobald jedoch höhere Zugkräfte auftreten, welche die eingangs beschriebenen Probleme verursachen können, erfolgt eine selbsttätige Öffnung.

Beim Zusammenführen der beiden Vorrichtungsteile 12, 14 bewegen sich diese entlang der Verbindungsachse 54. Beispielsweise wird das erste Vorrichtungsteil 12 in eine Einsteckrichtung 56 geführt. Beim Trennen bewegen sich die beiden Vorrichtungsteile 12, 14 entlang der Verbindungsachse 54 auseinander.

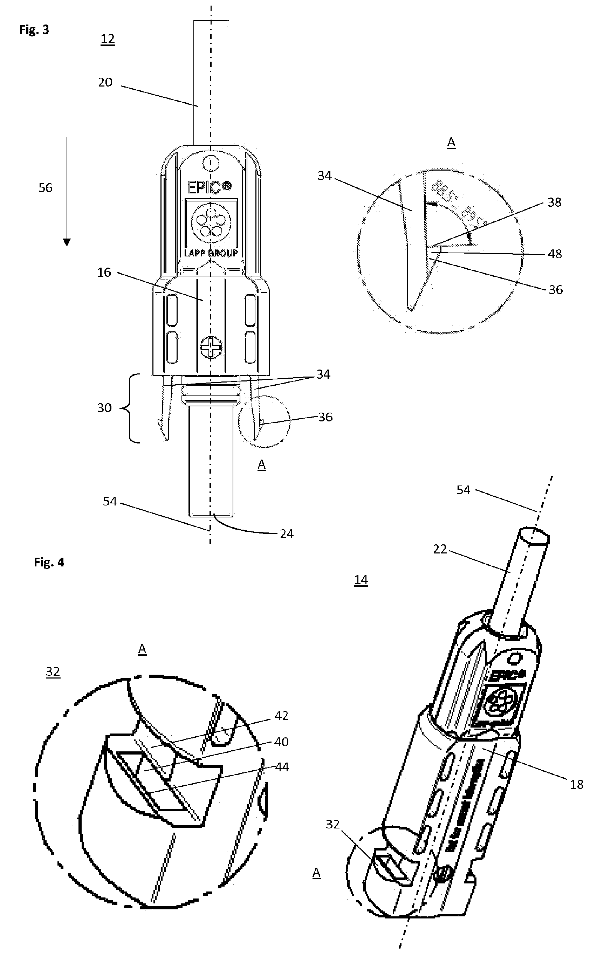

Figur 2 zeigt das erste Vorrichtungsteil 12 mit einem zugehörigen ersten Verriegelungselement 30 in einer Detailansicht. Das Verriegelungselement 30 weist einen Rastkörper 36 auf, welcher im Endbereich eines Hebels 34 angeordnet ist (siehe auch Figur 3). Der Rastkörper 36 ist keilförmig ausgestaltet und bildet mit der Frontseite des Hebels 34 eine um vorzugsweise 45° zur Verbindungsachse 54 geneigte Frontfläche, welche das Einführen in das zweite Verriegelungselement 32 erleichtert. Auf der Rückseite des keilförmigen Rastkörpers 36 ist eine Keilfläche 38 vorgesehen, die nach der Verbindung der Vorrichtungsteile 12, 14 an einer Auflagefläche 44 des zweiten Verriegelungselements 32 des zweiten Vorrichtungsteils 14 anliegt und die Verriegelung bewirkt.

Die Breite der Keilfläche 38 beträgt an der am Hebel 34 anliegenden Basis vorzugsweise 4,5mm. An der freiliegenden Keilkante weist die Keilfläche 38 eine Breite von vorzugsweise 3mm auf. Auf beiden Seiten des Rastkörpers 36 schliesst je eine geneigte Seitenfläche 48 an die Keilfläche 38 an. Damit wird das Zusammenführen der Vorrichtungsteile 12, 14 bzw. der Verriegelungselemente 30, 32 erleichtert. Zusätzlich wird verhindert, dass Teile des Rastkörpers 36 unter Last oder bei mehrfacher Betätigung der Verbindungsvorrichtung 10 abgebrochen oder abgetragen werden.

Figur 3 zeigt eine Seitenansicht des erfindungsgemässen ersten Vorrichtungsteils 12 und eine Detailansicht des ersten Verriegelungselements 30.

Das zungenförmige erste Verriegelungselement 30 weist einen Hebel 34 auf, der an einem Ende fest mit dem Gehäuse 16 verbunden ist. Der Hebel 34, weist vorzugsweise eine Länge von 10mm, eine Breite von 6mm und eine sich zum Rastkörper 36 hin verringernde Dicke von 0,5mm - 1,5mm auf.

Der Rastkörper 36 ist im Endbereich des Hebels 34 angeordnet und weist zusammen mit der Frontseite des Hebels 34 eine geneigte Frontfläche auf. Auf der Rückseite des Keils befindet sich die Keilfläche 38. Diese weist gegenüber dem Hebel 34 einen Winkel im Bereich von 88,5° - 89,5° auf. Die Höhe der Keilfläche 38 beträgt im gezeigten Beispiel 0,5mm.

Figur 4 zeigt das zweite Vorrichtungsteil 14 mit einer Detailansicht des zweiten Verriegelungselementes 32. Das zweite Verriegelungselement 32 besteht aus einem Tunnel 40, in den das erste Verriegelungselement 30 eingeführt wird. Die Breite des Tunnels 40, der parallel zur Verbindungsachse 54 verläuft, ist z.B. um 10-20 % grösser als die Breite des Hebels 34. Die Länge des Tunnels 40 entspricht der Länge des Hebels 34 bis zur Keilfläche 38.

Beim Zusammenführen der beiden Vorrichtungsteile 12, 14 der Verbindungsvorrichtung 10, durchläuft das erste Verriegelungselement 30 den Tunnel 40 und erreicht an dessen Ende die Rastsenke 42. Beim vollständigen Durchstossen des Rastkörpers 36 rastet dieser mit seiner Keilfläche 38 an der Auflagefläche 44 ein, welche am Ende des Tunnels 40 von der Verbindungsachse 54 abgewandt angeordnet ist. Die Auflagefläche 44 weist eine Höhe von 0,4mm auf und liegt vorzugsweise senkrecht zum Tunnel 40. Die erstellte Verriegelung kann manuell durch Hinunterdrücken des Rastkörpers 36 wieder gelöst werden.

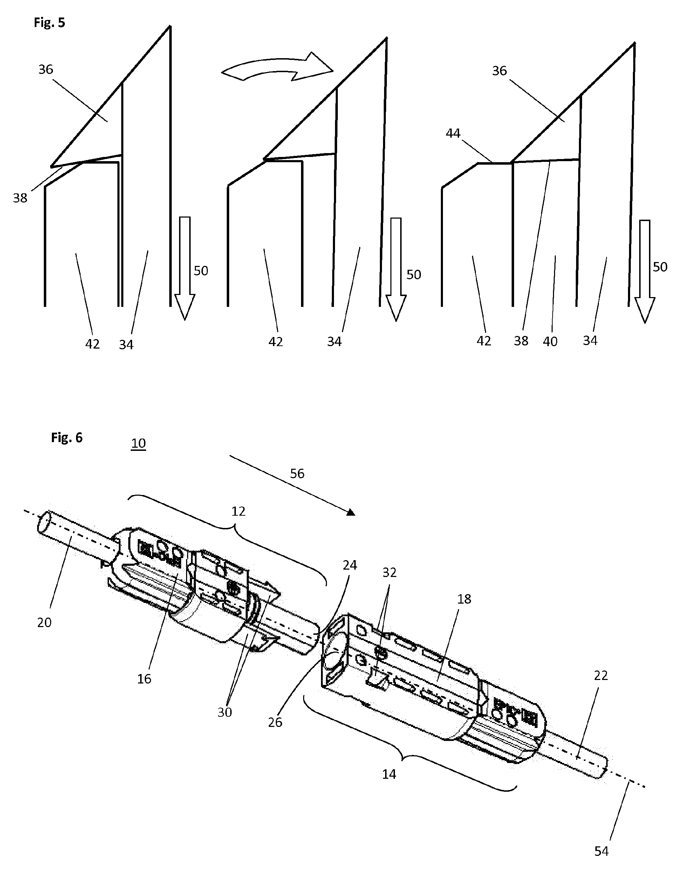

Beim Auftreten einer Zugkraft, die über der definierten Zugkraft liegt, erfolgt die selbsttätige Entriegelung der Verbindungsvorrichtung 10. Figur 5 zeigt drei Zustände des ersten Verriegelungselements 30 während des Entriegelungvorgangs.

Die erste Darstellung zeigt die miteinander verbundenen ersten und zweiten Verriegelungselemente 30, 32 in einem ersten Zustand, in dem der verriegelte Rastkörper 36 mit seiner hinteren Keilfläche 36 an der Frontseite des Tunnels 40 bzw. an der Auflagefläche 44 anliegt. Dieser Zustand wird aufrechterhalten, bis die definierte Zugkraft 50 überschritten wird.

Die zweite Darstellung zeigt die beiden Verriegelungselemente 30, 32 nach Erhöhung der Zugkraft 50 bis zum definierten Grenzwert, bei dem das selbsttätige Öffnen der Verbindungsvorrichtung 10 erfolgen soll. Bei diesem Zustand wird der Rastkörper 36 mit der Keilfläche 38 stark gegen die Frontseite des Tunnels 40 bzw. gegen die Auflagefläche 44 gedrückt. Somit resultieren zwei etwa gleich grosse Kräfte, die in einem etwa der Höhe des Rastkörpers 36 entsprechenden Abstand zumindest annähernd parallel zueinander verlaufen. Die erste Kraft, nämlich die Zugkraft 50 wirkt auf den Hebel 34 ein. Die zweite Kraft wirkt zwischen der Keilfläche 38 des Rastkörpers 36 und der Auflagefläche 44. Der Hebel 34 erfährt somit ein Drehmoment, welches dessen frontseitiges Ende gegen die Verbindungsachse 54 drückt.

Die dritte Darstellung zeigt die beiden Verriegelungselemente 30, 32 nach der Erhöhung der Zugkraft 50 über den definierten Grenzwert. Durch die weitere Erhöhung des Drehmoments wurde das frontseitige Ende des Hebels 34 soweit zur Seite gedrückt, bis der Rastkörper 36 an der Auflagefläche 44 nicht mehr aufliegt und durch den Tunnel 34 entweichen kann.

Durch die Dimensionierung des Hebels 34 und des Rastkörpers 36 und unter Berücksichtigung des verwendeten Materials kann der Grenzwert für die Zugkraft eingestellt werden. Dabei wird von den oben genannten Angaben ausgegangen. Durch Reduktion oder Vergrößerung der Dimensionen kann der Grenzwert wahlweise nach unten und nach oben verschoben werden. Dabei ist es auch möglich, den Hebel 34 zur Frontseite hin zu verjüngen und dadurch zu flexibilisieren.

Figur 6 zeigt eine weitere erfindungsgemässe Verbindungsvorrichtung 10 mit einem ersten Vorrichtungsteil 12, welches zungenförmige erste Verriegelungselemente 30 mit einem Hebel 34 und zwei Rastkörpern 36 aufweist, die seitlich an der Frontseite des Hebels 34 angeordnet sind.

Gezeigt ist ferner das zweite Vorrichtungsteil 14, welches zweite Verriegelungselemente 32 mit je einem Tunnel 40 aufweist, von denen jeder zwei Rastsenke 42 umfasst, die durch einen Steg zwischen Tunnel 40 und Gehäuse 18 voneinander getrennt sind. Bei dieser Verbindungsvorrichtung 10 kann die Verriegelung des ersten und zweiten Vorrichtungsteils 12, 14 nicht durch Hinunterdrücken der Hebels 34 von Hand gelöst werden. Zum Lösen dieser Verbindungsvorrichtung 10 wird ein spezielles Werkzeug benötigt. Dadurch kann verhindert werden, dass Unbefugte in einer Fotovoltaik-Anlage die Verbindungen lösen und gegebenenfalls Fotovoltaik-Module ohne Zerstörung der Leitungen 20, 22 entfernen können.

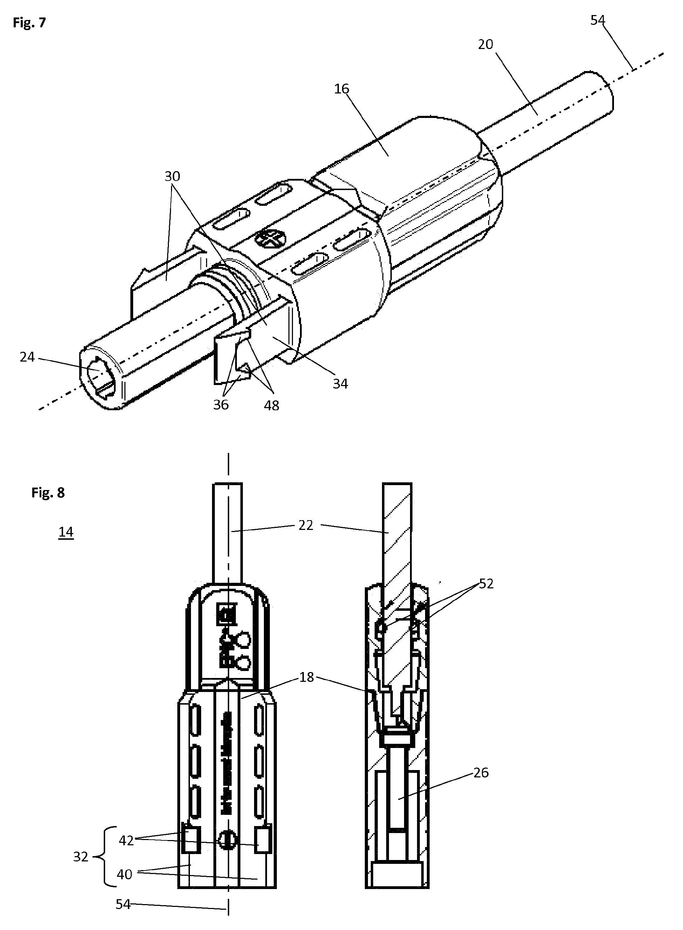

Figur 7 zeigt das erste Vorrichtungsteil 12 von Figur 6 in räumlicher Darstellung, mit den ersten Verriegelungselementen 30, die je einen Hebel 34 mit zwei voneinander getrennten Rastkörpern 36 aufweisen. Die Summe der rückseitigen Keilflächen 38 der beiden Rastkörper 36 entspricht vorzugsweise der Fläche eines in den Figuren 1-3 gezeigten mittig angeordneten Rastkörpers 36. Somit entspricht die Breite der Basis der Rastkörper 36 etwa 2,3mm während die freiliegenden Keilkanten etwa 1,5mm Breit sind.

Figur 8 zeigt eine Seitenansicht und eine Schnittansicht des zweiten Vorrichtungsteils 14 von Figur 6. In der Schnittansicht ist die Verbindung zwischen der Leitung 22 und dem Vorrichtungsteil 14 gezeigt. Die Verbindung muss relativ grosse Zugkräfte 50 aufnehmen können, die über die Leitung 22 einwirken. Dies kann beispielsweise durch eine Zugentlastung 52 geschehen, die vorzugsweise eine Zugkraft von mindestens 300N aufnehmen kann.

### Bezugszeichenliste

- 10: Verbindungsvorrichtung
- 12: erstes Vorrichtungsteil
- 14: zweites Vorrichtungsteil
- 16: erstes Gehäuse
- 18: zweites Gehäuse
- 20: erste Leitung
- 22: zweite Leitung
- 24: erster Anschlusskontakt
- 26: zweiter Anschlusskontakt
- 30: erstes Verriegelungselement
- 32: zweites Verriegelungselement
- 34: Hebel
- 36: Rastkörper
- 38: rückseitige Keilfläche
- 40: Tunnel
- 42: Rastsenke
- 44: Auflagefläche
- 48: geneigte Seitenflächen
- 50: Zugkraft
- 52: Zugentlastung
- 54: Verbindungsachse
- 56: Einsteckrichtung

## Patentansprüche

1. Verbindungsvorrichtung (10) für elektrische Leitungen, insbesondere für Leitungen von Fotovoltaik-Geräten, mit einem der Verbindung mit mindestens einer ersten Leitung (20) dienenden ersten Vorrichtungsteil (12), welches ein erstes Gehäuse (16) und wenigstens einen darin vorgesehenen ersten Anschlusskontakt (24) aufweist, mit einem der Verbindung mit mindestens einer zweiten Leitung (22) dienenden zweiten Vorrichtungsteil (14), welches ein zweites Gehäuse (18) und wenigstens einen darin vorgesehenen zweiten Anschlusskontakt (26) aufweist, sowie mit einer Verriegelungsvorrichtung, die wenigstens ein am ersten Gehäuse (16) vorgesehenes erstes und wenigstens ein am zweiten Gehäuse (18) vorgesehenes zweites Verriegelungselement (30, 32) aufweist, die beim Verbinden der beiden Vorrichtungsteile (12, 14) miteinander koppelbar sind;
**dadurch gekennzeichnet, dass** die beiden Verriegelungselemente (30, 32) wenigstens teilweise zueinander komplementäre Formen aufweisen, die nach dem Verbinden der beiden Vorrichtungsteile (12, 14) zumindest teilweise formschlüssig aneinander liegen und dass wenigstens eines der beiden Verriegelungselemente (30, 32) elastisch ausgestaltet und unter Einwirkung einer definierten Zugkraft (50), welche auf einer der Leitungen (20, 22) zumindest annähernd parallel zu einer Verbindungsachse (54) einwirkt, derart deformierbar ist, dass die formschlüssige Verbindung selbsttätig und zerstörungsfrei lösbar ist.

2. Verbindungsvorrichtung (10) nach Anspruch 1, **dadurch gekennzeichnet, dass** das erste Verriegelungselement (30) zungenförmig ausgestaltet ist und wenigstens einen Hebel (34) aufweist, in dessen Endbereich wenigstens ein vorzugsweise keilförmig ausgestalteter Rastkörper (36) angeordnet ist und dass das zweite Verriegelungselement (32) einen der Aufnahme des Hebels (34) dienenden Tunnel (40) sowie eine der Aufnahme des Rastkörpers (36) dienende Rastsenke (42) aufweist.

3. Verbindungsvorrichtung (10) nach Anspruch 2, **dadurch gekennzeichnet, dass** der Hebel (34) und der Tunnel (40) annähernd parallel zu der Verbindungsachse (54) ausgerichtet und entlang der beiden Vorrichtungsteile (12, 14) ineinander verschiebbar sind.

4. Verbindungsvorrichtung (10) nach Anspruch 2 oder 3, **dadurch gekennzeichnet, dass** der Rastkörper (36) am Ende des Hebels (34) mittig angeordnet ist oder dass zwei voneinander beabstandete Rastkörper (36) am Ende des Hebels (34) seitlich angeordnet sind.

5. Verbindungsvorrichtung (10) nach einem der Ansprüche 2 - 4, **dadurch gekennzeichnet, dass** der Rastkörper (36) eine rückseitige Keilfläche (38) aufweist, die im verriegelten Zustand wenigstens teilweise an einer Auflagefläche (44) der zugehörigen Rastsenke (42) anliegt.

6. Verbindungsvorrichtung (10) nach Anspruch 5, **dadurch gekennzeichnet, dass** die Keilfläche (38) mit der Verbindungsachse (54) bzw. dem Hebel (34) einen Winkel im Bereich 85° - 89.5°, vorzugsweise im Bereich 88.5° - 89.5°, einschliesst.

7. Verbindungsvorrichtung (10) nach einem der Ansprüche 5 - 6, **dadurch gekennzeichnet, dass** die Höhe der Keilfläche (38) im Bereich von 0,3mm - 1,5mm liegt und die gesamt Breite der Keilfläche (38) des wenigstens einen Rastkörpers (36) im Bereich von 2mm - 6mm liegt.

8. Verbindungsvorrichtung (10) nach einem der Ansprüche 5 - 7, **dadurch gekennzeichnet, dass** die Auflagefläche (44) am Ende des Tunnels (40), vorzugsweise auf der der Verbindungsachse abgewandten Seite des Tunnels (40), liegt und zumindest annähernd senkrecht zur Verbindungsachse (54) ausgerichtet ist.

9. Verbindungsvorrichtung (10) nach einem der Ansprüche 5 - 8, **dadurch gekennzeichnet, dass** die Höhe der Auflagefläche (44) im Bereich 0,2mm - 0,6mm liegt.

10. Verbindungsvorrichtung (10) nach einem der Ansprüche 5 - 9, **dadurch gekennzeichnet, dass** die Keilfläche (38) eine geringere Breite aufweist als die Vorderkante des Hebels (34) wobei der Rastkörper (36) zur Verbindungsachse (54) geneigte Seitenflächen (48) aufweist.

11. Verbindungsvorrichtung (10) nach einem der Ansprüche 2 - 10, **dadurch gekennzeichnet, dass** der Hebel (34) eine Länge im Bereich von 7mm - 15mm aufweist und eine radial zur Verbindungsachse (54) verlaufende Dicke im Bereich von 0,5mm - 2mm und eine senkrecht zur Länge und Dicke verlaufende Breite im Bereich von 4mm - 9mm.

12. Verbindungsvorrichtung (10) nach einem der Ansprüche 1 - 11, **dadurch gekennzeichnet, dass** die Verriegelungselemente (30, 32) eine zumindest annähernd axial zur Verbindungsachse (54) verlaufende Zugkraft (50) im Bereich von 50N - 300N, vorzugsweise 80N - 150N aufzunehmen vermögen.

13. Verbindungsvorrichtung (10) nach einem der Ansprüche 1 - 12, **dadurch gekennzeichnet, dass** eine Verbindung zwischen der Leitung (20, 22) und dem zugehörigen Vorrichtungsteil (12, 14) besteht, welche eine zumindest annähernd axial zur Verbindungsachse (54) verlaufende Zugkraft (50) im Bereich von 300N - 500N aufzunehmen vermag.

14. Verbindungsvorrichtung (10) nach einem der Ansprüche 1 - 13 **dadurch gekennzeichnet, dass** nach dem Trennen der beiden Vorrichtungsteile (12, 14) durch axiale Zugkraft (50) auf einer der Leitungen (20, 22), elektrische Energie führende Teile durch eine genügende Isolation gegen Berührung geschützt bleiben.

15. Verbindungsvorrichtung (10) nach einem der Ansprüche 1 - 14 **dadurch gekennzeichnet, dass** die Vorrichtungsteile (12, 14) mindestens teilweise aus modifiziertem PPE bestehen.
